# FASCICULE DE BREVET EUROPEEN

(11) **EP 1 099 505 B1**
(45) Date de publication et mention de la délivrance du brevet: **01.09.2004**
(21) Numéro de dépôt: 00203908.9
(22) Date de dépôt: 08.11.2000
(51) Int. Cl.: B23K 20/02, H01Q 1/46, G01S 13/75, B23K 101/42, H01L 21/603

(54) **Dispositif d'assemblage par thermocompression pour la connexion d'un fil sur un circuit intégré**
Vorrichtung zur Thermokompressionsammlung eines Drahtes mit einem IC
Thermocompression assembling device used to connect together a wire with an IC

(30) Priorité: 09.11.1999 FR 9914059
(43) Date de publication de la demande: 16.05.2001
(73) Titulaire: G.S. Automation SA, 1228 Plan-les-Ouates (Genève) (CH)
(72) Inventeur: Van der Meer, Mathijs Pieter, 1218 Grand-Saconnex (Genève) (CH)
(74) Mandataire: Kiliaridis, Constantin

(56) Documents cités:
- EP-A- 0 032 437
- EP-A- 0 567 124
- EP-A- 0 771 604
- "Tab package lead bonding thermode with ruby head" IBM TECHNICAL DISCLOSURE, vol. 33, no. 3a, août 1990 (1990-08), page 371 XP000123978 armonk ny, usa

## Description

L'invention concerne un dispositif d'assemblage par thermocompression d'un fil sur un circuit intégré comprenant un corps muni à une extrémité d'une tête en diamant ayant une forme au moins approximativement conique dont la pointe est libre et située dans le prolongement du corps, ladite tête étant destinée à s'appliquer sous pression sur les éléments à assembler et assurer une conduction thermique entre une source de chaleur et lesdits éléments.

Cette invention se rapporte plus particulièrement aux méthodes et appareils servant à lier des fils notamment des fils d'antenne à des plages de contact de circuits intégrés. Plus précisément cette invention se rapporte spécialement à la liaison par thermocompression de fils de connexion d'antennes composés de fil de cuivre sur des plages de contact de circuits intégrés, dans le but d'obtenir un dispositif d'identification par fréquence radio très compact.

L'utilisation de circuits d'identification par fréquence radio (RFID) dans des cartes à puce sans contact ou d'autres petits objets portables (clés, montres etc...) implique le besoin de modules transpondeurs très compacts. Si le module doit être incorporé dans une carte d'épaisseur inférieure à 0,8mm (norme ISO), il est évident que l'épaisseur du module doit être aussi faible que possible. Un module plat facilite le moulage si la carte est produite par injection, et permet d'obtenir une surface lisse si la carte est produite par laminage. Des exemples de modules transpondeurs miniaturisés sont donnés dans les documents US 4'999'742 et 5'025'550, ainsi que dans le document EP-B-0 526 484. Toutes ces méthodes ont en commun le fait qu'au moins une pièce intermédiaire est requise entre le circuit intégré et les fils de l'antenne pour faciliter leur connexion, ce qui a pour effet d'augmenter la taille du transpondeur. Une méthode est décrite dans US-A-5'281'855 pour faciliter l'interconnexion de fils d'antenne sur un circuit intégré au moyen d'électrodes de grande surface plaquées sur la couche de passivation du circuit intégré, qui permet d'obtenir un assemblage final de dimensions réduites. Cependant cette méthode induit des étapes supplémentaires dans le processus de fabrication du circuit intégré, augmentant ainsi les coûts de production.

Il est clair pour la personne du métier qui considère la production en masse de ce genre de dispositif, que toute réduction du nombre de pièces requises pour l'assemblage d'un module entraîne une réduction significative des coûts de production, du fait que toutes les pièces concernées sont de dimensions réduites et difficiles à manipuler.

Dans le domaine du microcâblage (wirebonding), l'utilisation de fils d'antennes présente une difficulté qui n'a pas été abordée, du moins à la connaissance de l'inventeur: les fils d'antenne sont recouverts d'une couche isolante, et très souvent ils sont également couverts d'une deuxième couche de thermoplastique. Il est difficile de retirer la couche isolante du fil avant l'assemblage, mais elle peut être détruite pendant l'assemblage, par exemple en utilisant la température élevée de l'outil d'assemblage. Dans ce cas il est important que des restes de vernis ne collent pas à l'outil, car une couche de résidus réduit la transmission de chaleur entre l'outil et le fil, ce qui nuit gravement à la qualité du lien entre le fil et le circuit intégré. Il a également été observé qu'une fine couche de restes de vernis brûlés sur des outils métalliques peut suffire à provoquer l'adhésion du fil à l'outil d'assemblage plutôt qu'au circuit intégré. Dans ces conditions il est nécessaire de nettoyer fréquemment l'outil d'assemblage, ce qui nuit à la cadence de la machine.

Du fil de cuivre a été largement utilisé dans le passé pour relier les plages de contact (plages) de circuits intégrés aux pattes de contact des boîtiers de circuits intégrés. Il est bien connu que le fil de cuivre est plus difficile à lier par thermocompression que du fil d'or ou d'aluminium, en raison de sa dureté relative. A cause de cette dureté le cuivre nécessite une température et une pression élevées pour former un lien solide avec le circuit intégré. Cette nécessité peut mener à de nombreux défauts du produit fini, la haute pression pouvant entraîner la rupture du circuit intégré, spécialement lorsqu'elle est associée avec le choc thermique occasionné par la température élevée. Un autre désavantage lié aux températures élevées est le risque de destruction de la couche de passivation du circuit intégré, qui peut mener à des courts circuits entre le fil de connexion et le bord périphérique du matériau semi-conducteur du substrat.

De nombreuses recherches ont été effectuées pour essayer de contourner ce problème. Par exemple, le EP-A-0 413 937 présente une méthode pour l'électrodéposition d'une couche de métal tendre sur l'extrémité d'un contact de cuivre, qui rend possible l'élaboration de liens solides à une température de 350°C. Malheureusement, une telle méthode ne peut être employée avec du fil généralement utilisé pour la fabrication de bobines d'antennes. Ceci est dû à la difficulté, mentionnée précédemment, de détruire la couche de vernis isolant qui empêche l'électrodéposition de métal. La déposition de minuscules boules d'or sur les plages du circuit intégré pourrait constituer une solution au problème, mais entraînerait une augmentation déraisonnable des coûts de production.

Dans le EP-A-0 771 604 on propose un outil de soudure par thermocompression comprenant un diamant placé à son extrémité, pour lier des composants électroniques à un circuit imprimé.

L'avantage principal de l'utilisation du diamant pour former la pointe de l'outil est la bonne conductibilité thermique du diamant, entre 3 et 5 fois plus élevée que celle du cuivre (Cu), entre 5 et 9 fois plus élevée que celle de l'aluminium (Al), et entre 8 et 14 fois plus élevée que celle du silicium (Si). Ainsi la chaleur peut être transmise beaucoup plus rapidement de l'outil d'assemblage à l'interface entre le fil et la plage, que de l'interface au circuit intégré. Ceci signifie que dans l'interface la température permettant la formation d'un lien entre le fil et la plage est atteinte beaucoup plus rapidement qu'en utilisant un outil composé de métal dur de type couramment rencontré dans le domaine du microcâblage.

Un autre avantage de l'utilisation du diamant dans la réalisation de l'outil par rapport à d'autres matériaux est l'importante résistance à l'abrasion du diamant liée à sa dureté.

Encore un autre avantage lié à l'utilisation de diamant est sa grande inertie chimique. Ainsi il est possible de brûler la couche d'isolant sans dégradation chimique de l'outil d'assemblage, à une température suffisamment élevée pour prévenir l'encrassement de l'outil.

Le dispositif décrit dans le EP-A-0 771 604 ne donne pas satisfaction pour l'assemblage de fils sur des circuits intégrés. Ceci est dû au coefficient de dilatation du diamant, beaucoup plus faible que ceux des métaux bons conducteurs de chaleur tels que le cuivre ou l'argent. Lorsque la température de l'outil d'assemblage dépasse environ 400°C, de fortes contraintes apparaissent entre le diamant et le corps de l'outil d'assemblage, entraînant la chute du diamant.

Après avoir créé la liaison entre le fil et le circuit intégré, il faut supprimer la partie inutile du fil de connexion pour éviter la formation de courts-circuits. Une méthode couramment utilisée consiste à exercer une traction sur le fil pour le rompre, alors que l'outil d'assemblage reste en place sur la plage pour réduire la contrainte sur le lien. Cette méthode donne de bons résultats avec des fils d'or fins, mais elle est inefficace dans le cas de fil de cuivre en raison de sa solidité. Au lieu de se rompre, le fil est alors fréquemment arraché de la plage. Diverses méthodes existent pour fragiliser le fil à proximité du lien avant de lui faire subir la traction. L'inconvénient de toutes ces méthodes est soit la complexité accrue dans la fabrication du dispositif d'assemblage, soit le nombre d'étapes supplémentaires requises par la méthode d'assemblage. Le document EP-A-0 032 437 décrit un dispositif selon le préambule de la revendication 1.

Afin de résoudre les problèmes mentionnés précédemment, un des objectifs de cette invention est de permettre la réalisation d'un outil d'assemblage capable de lier un fil de cuivre standard à une plage de circuit intégré composé d'aluminium ou d'un alliage d'aluminium sans endommager le circuit intégré, et sans nécessiter de traitement supplémentaire du fil de cuivre ou de la plage.

Un autre objectif de cette invention est de fournir un outil d'assemblage capable de souder par thermocompression du fil de bobine isolé, tout en retirant l'isolant et les éventuelles couches de thermoplastique dont est enduit le fil, mais ne nécessitant pas ou du moins très peu d'entretien supplémentaire, par rapport au même outil d'assemblage utilisé pour lier du fil de cuivre nu.

La présente invention rend ceci possible par l'utilisation d'un dispositif d'assemblage caractérisé par le fait que la tête est assemblée sur le corps par des moyens empêchant le déchaussement de la tête dû à des coefficients de dilatation thermique différentielle.

Pour pallier le déchaussement du diamant, on propose aux revendications 2 à 4 des moyens empêchant le déchaussement.

Il est un autre objet de cette invention de fournir un outil d'assemblage capable de fragiliser le fil localement à proximité du lien, dans le but de faciliter l'enlèvement du résidu de fil inutile après la formation du lien, de telle manière que la fragilisation soit produite par la même opération que celle donnant lieu à la formation du lien, et également de telle manière qu'il ne soit pas nécessaire de garder l'outil d'assemblage en place sur le lien pendant la rupture du fil.

Ceci peut être réalisé en donnant à la pointe de diamant une forme dissymétrique, telle que défini à la revendication 5, de sorte à ce que le fil soit aplati brutalement d'un coté de l'outil d'assemblage, alors qu'il est aplati progressivement de l'autre.

Ainsi il dévient possible de connecter directement des fils de connexion d'antenne sur des plages de circuits intégrés, sans la nécessité de recourir à des pièces intermédiaires entre les fils et les plages.

D'autres objectifs, caractéristiques et avantages de la présente invention apparaîtront par la suite dans la description détaillée et les dessins qui l'accompagnent.

**La Figure 1** est une vue en coupe latérale d'un outil d'assemblage qui n'est pas protégé dans le brevet présent.

**La Figure 2** est une vue en coupe latérale d'une variante d'exécution.

**La Figure 3** est une vue en coupe latérale d'une deuxième variante d'exécution.

**La Figure 4** est un agrandissement d'une vue en coupe latérale de la pointe en diamant reposant sur le fil après la formation du lien.

**La Figure 5** représente la coupe selon la ligne A-A de la figure 4 vue de dessus, de la pointe en diamant reposant sur le fil selon une variante d'exécution.

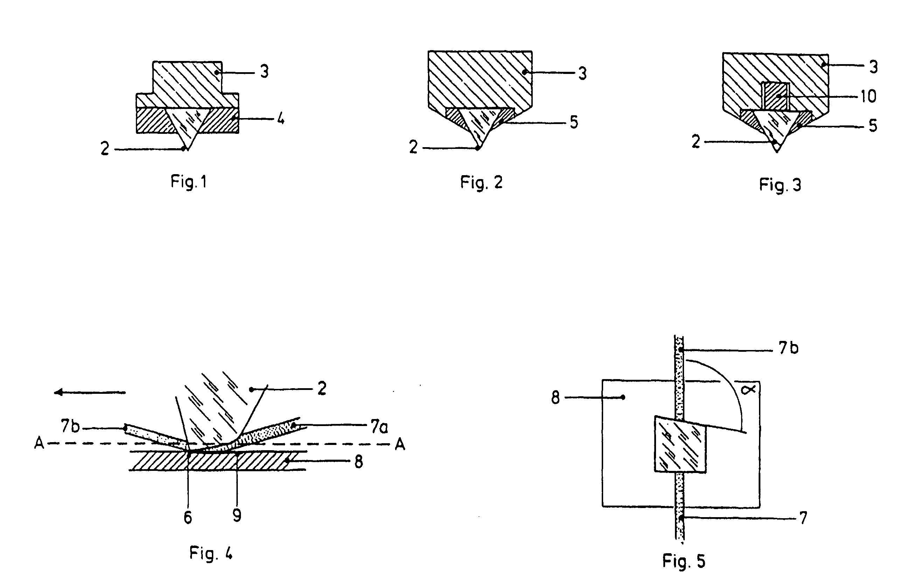

L'outil d'assemblage représenté sur la FIGURE 1 comprend une tête constituée d'un petit diamant 2, fixé sur un corps 3. La forme essentiellement conique du diamant lui permet d'être tenu en place solidement sur le corps 3 au moyen d'un support de fixation 4 comprenant un trou traversant de forme conique identique à celle du diamant 2. Ainsi, les coefficients de dilatation thermique différentiels ne parviennent pas à déchausser le diamant 2, même lorsque ce dernier est de grande taille et la température de l'outil d'assemblage élevée. Avec la forme mentionnée précédemment, la température de l'outil d'assemblage n'est limitée que par l'oxydation thermique du diamant, qui se produit aux alentours de 650 à 700°C dans l'air. En travaillant en atmosphère protégée, le diamant 2 peut encore être amené à des températures plus élevées sans risque de tomber hors du support de fixation 4. La pièce de fixation 4 peut être fixée au corps 3 de manière définitive, par exemple par soudure, ou alors de manière non définitive, par exemple au moyen de vis, afin de pouvoir être retirée par la suite. Ceci peut s'avérer utile, par exemple en cas de rupture de la pointe du diamant 2, pour pouvoir le remplacer.

Dans le cas où la chaleur de l'outil d'assemblage est produite au moyen d'une résistance, il est évident que le corps 3 ou le support de fixation 4 doivent être constitués d'un matériau conduisant bien la chaleur, par exemple Cu, Ag ou Al, car la chaleur doit alors être transmise par au moins une de ces pièces, préférentiellement les deux. Plusieurs autres méthodes peuvent être utilisées pour chauffer la pointe, comme décrits par exemple dans les documents US 3'838'240, 3'891'822, 4'315'128, 4'529'115, 4'821'944, de même que dans le EP-B-0 150 305. Le recours à l'une de ces méthodes peut rendre préférable l'utilisation d'un matériau qui soit un mauvais conducteur thermique.

Dans une forme d'exécution représentée dans la FIGURE 2, le diamant 2 est brasé à l'intérieur du corps 3. L'avantage principal de cette forme est la simplification de la fabrication de l'outil de soudure, car la forme de la brasure 5 est parfaitement adaptée à celle du diamant 2 sans nécessiter d'ajustement précis. La brasure de diamants est une opération courante dans l'industrie des outils de coupe, et peut être effectuée à l'air selon US-A-5'500'248.

On ne saurait exclure totalement le risque que le diamant prenne du jeu en raison des différences entre le coefficient de dilatation du diamant et celui du matériau environnant.

La FIGURE 3 présente une construction dans laquelle cet effet est annulé en appuyant le haut du diamant sur une pièce 10 constituée d'un matériau au coefficient de dilatation supérieur à celui du matériau environnant.

La suppression après l'assemblage du résidu de fil inutile 7b peut être facilitée en donnant une forme asymétrique à la pointe du diamant, comme le montre la FIGURE 4. La pointe 2 est montrée agrandie dans une vue en coupe latérale reposant sur le fil de cuivre 7 après que l'assemblage ait eu lieu sur la plage 9 d'un circuit intégré 8. Un angle vif 6 taillé sur le diamant 2 du coté du résidu de fil inutile 7b produit un aplatissement brutal du fil qui le fragilise considérablement et permet de le sectionner facilement en tirant dans la direction parallèle à la surface du circuit intégré 8 comme indiqué par la flèche. Ainsi, le résidu de fil inutile peut-être enlevé sans arracher le fil utile 7a de la plage 9, même après avoir retiré l'outil du fil 7.

D'autres formes peuvent être utilisées pour faciliter la rupture du fil, tel qu'un bord du diamant faisant un angle a avec la direction du fil différent de 90°, comme illustré par la FIGURE 5. Cet angle α différent de 90° crée une section entre la partie aplatie du fil et le résidu oblique qui facilite l'amorce de rupture.

Un avantage de la présente invention réside dans le fait que le lien est très plat comme le montre la FIGURE 4, en comparaison avec d'autres techniques connues telles que le "ball bonding".

La présente invention constitue donc un outil utile pour la réalisation de produits nécessitant une très faible épaisseur, tels que des cartes à puce.

Dans une forme d'exécution préférée, la pointe de l'outil d'assemblage est constituée d'un diamant monocristallin. Le diamant polycristallin est relativement fragile, et de petits cristaux de diamant se détachent facilement de la pointe, parfois déjà lors de la taille. Un inconvénient supplémentaire du diamant polycristallin est qu'il s'encrasse plus vite du fait que sa surface est moins lisse.

Au moment où la pointe est mise en contact avec le fil pour réaliser le lien, la chaleur s'écoule très rapidement du diamant dans le fil et dans le substrat du circuit intégré. Ainsi, alors que la température à l'intérieur du lien augmente brutalement, celle de la pointe diminue tout aussi brutalement. Il est évident que le diamant doit posséder une taille minimale en dessous de laquelle sa température tomberait trop rapidement, empêchant la température de l'interface entre le fil et la plage d'atteindre un niveau suffisant. La chaleur spécifique volumique du diamant est similaire à celle du Si, et la moitié de celle du Cu. Un diamant aux dimensions d'environ 4mm³ a permis de lier des fils de manière très satisfaisante.

Un diamant de forme générale conique est brasé sur un corps constitué de cuivre-béryllium. Ensuite la pointe est taillée dans une forme similaire à celle représentée dans la FIGURE 4, avec trois facettes orientées sous un angle d'environ 60°, et une facette orientée sous un angle d'environ 45° par rapport au plan horizontal. L'arête entre la surface de travail de la pointe essentiellement horizontale et la facette formant un angle de 45° avec le plan horizontal est arrondi ou cassé dans le but de ne pas blesser la partie utile du fil. La surface de travail de la pointe possède des dimensions similaires à celles des plages du circuit intégré.

Pour faciliter l'assemblage, c'est-à-dire la formation du lien, le dispositif peut être muni de moyens permettant d'appliquer des vibrations. Ces moyens pourraient être des moyens à ultrasons.

Le fait que la température de la pointe reste élevée pendant l'assemblage présente trois avantages.

Tout d'abord cela signifie que la température à l'intérieur du lien atteint pratiquement la température initiale de la pointe, et ainsi la pression requise est inférieure à celle qui serait nécessaire avec une pointe constituée de métal. Il a ainsi été possible d'appliquer une pression suffisamment faible pour lier des fils sur des circuits intégrés d'une épaisseur de 0,15mm.

Ensuite la pression peut être appliquée pendant un laps de temps extrêmement court, ce qui permet de transférer une quantité minimale de chaleur au circuit intégré, insuffisante pour endommager le circuit intégré.

Finalement le fait que la température diminue faiblement pendant la liaison d'un fil entraîne la possibilité de réaliser des liens successifs très rapidement sans avoir à attendre que la pointe regagne sa température d'origine, à condition bien sûr d'utiliser une source de chaleur d'une puissance adaptée pour chauffer la pointe.

## Revendications

1. Dispositif d'assemblage par thermocompression d'un fil sur un circuit intégré comprenant un corps (3) muni à une extrémité d'une tête (2) en diamant ayant une forme au moins approximativement conique dont la pointe est libre et située dans le prolongement du corps (3), ladite tête (2) étant destinée à s'appliquer sous pression sur les éléments (7, 8) à assembler et assurer une conduction thermique entre une source de chaleur et lesdits éléments, **caractérisé par le fait que** la tête (2) est assemblée dans un trou de l'extrémité libre dudit corps (3) dans lequel la tête (2) est maintenue par brasure (5) couvrant partiellement la surface latérale de la tête (2) empêchant ainsi le déchaussement de la tête (2) dû à des coefficients de dilatation thermique différentielle.

2. Dispositif selon la revendication 1, **caractérisé par le fait que** la tête (2) s'appuie par sa base sur une pièce (10) constituée d'un matériau dont le coefficient de dilatation est supérieur à celui du matériau environnant.

3. Dispositif selon l'une des revendications 1 ou 2, **caractérisé par le fait que** l'extrémité de la tête (2) présente une surface plane destinée à écraser le fil (7, 7a, 7b) contre une plage (9) du circuit intégré (8), ladite surface étant légèrement inclinée de sorte à former une arête avec la surface latérale formant un angle vif (6) destiné à fragiliser le fil du côté de l'extrémité (7b) à découper du fil pour permettre de le sectionner facilement.

4. Dispositif selon l'une des revendications 1 à 3, **caractérisé par le fait que** l'extrémité de la tête (2) présente transversalement au fil (7) et du côté (7b) à découper une arête formant avec la direction du fil un angle (α) différent de 90°.

5. Dispositif selon l'une des revendications 3 ou 4, **caractérisé par le fait que** la pointe de la tête (2) est taillée de sorte à former quatre facettes dont une forme un angle d'environ 45° avec le plan du circuit intégré (8), l'angle formé entre cette facette et la face plane de l'extrémité étant arrondi ou cassé, tandis que les trois autres facettes forment un angle d'environ 60° avec le plan du circuit intégré.

6. Dispositif selon l'une quelconque des revendications 1 à 5, **caractérisé par le fait qu'**il est muni de moyens permettant d'appliquer des vibrations lors de l'assemblage.

## Patentansprüche

1. Vorrichtung zur Thermokompressionsmontage eines Drahtes auf einer integrierten Schaltung mit einem Körper (3), der an einem Ende mit einem Kopf (2) aus Diamant versehen ist, der eine zumindest annähernd konische Form aufweist und dessen Spitze frei ist und in Verlängerung des Körper (3) liegt, wobei der Kopf (2) unter Druck an den zu montierenden Elementen (7, 8) zur Anlage kommen soll und für eine Wärmeleitung zwischen einer Wärmequelle und den Elementen sorgt, **dadurch gekennzeichnet, dass** der Kopf (2) in einem Loch des freien Endes des Körpers (3) eingefügt ist, in dem der Kopf (2) durch eine Hartlötung (5) gehalten wird, die teilweise die Seitenfläche des Kopfs (2) bedeckt, wodurch die Freilegung des Kopfs (2) aufgrund der unterschiedlichen Wärmeausdehnungskoeffizienten verhindert wird.

2. Vorrichtung nach Anspruch 1, **dadurch gekennzeichnet, dass** der Kopf (2) über seine Basis an einem Teil (10) aufliegt, das aus einem Material besteht, dessen Ausdehnungskoeffizient größer als derjenige des umgebenden Materials ist.

3. Vorrichtung nach einem der Ansprüche 1 oder 2, **dadurch gekennzeichnet, dass** das Ende des Kopfs (2) eine plane Fläche aufweist, die den Draht (7, 7a, 7b) gegen einen Bereich (9) der integrierten Schaltung (8) drücken soll, wobei die Fläche geringfügig geneigt ist, so dass eine Kante mit der Seitenfläche gebildet wird, die eine scharfe Kante (6) bildet, die den Draht auf der Seite des abzuschneidenden Endes (7b) des Drahtes schwächen soll, um sein leichtes Abtrennen zu ermöglichen.

4. Vorrichtung nach einem der Ansprüche 1 bis 3, **dadurch gekennzeichnet, dass** das Ende des Kopfs (2) quer zum Draht (7) und auf der abzuschneidenden Seite (7b) eine Kante aufweist, die mit der Richtung des Drahts einen von 90° verschiedenen Winkel (α) bildet.

5. Vorrichtung nach einem der Ansprüche 3 oder 4, **dadurch gekennzeichnet, dass** die Spitze des Kopfs (2) so zugeschnitten ist, dass er vier Facetten bildet, von denen eine einen Winkel von etwa 45° mit der Ebene der integrierten Schaltung (8) bildet, wobei die zwischen dieser Facette und der ebenen Seite des Endes gebildete Ecke abgerundet oder gebrochen ist, während die drei anderen Facetten einen Winkel von etwa 60° mit der Ebene der integrierten Schaltung bilden.

6. Vorrichtung nach einem der Ansprüche 1 bis 5, **dadurch gekennzeichnet, dass** sie mit Mitteln versehen ist, die es gestatten, bei der Montage Vibrationen anzulegen.

## Claims

1. Device for joining a wire to an integrated circuit by thermocompression bonding, comprising a body (3) provided at one end with a diamond head (2) having at least approximately the shape of a cone, the tip of which is free and located in the extension of the body (3), the said head (2) being designed to be applied with pressure on the elements (7, 8) to be joined together and to ensure thermal conduction between a heat source and the said elements, **characterized in that** the head (2) is fitted into a hole in the free end of the said body (3) in which the head (2) is held in place by a braze (5) that partly covers the lateral surface of the head (2), thus preventing the head (2) from being removed due to differential thermoexpansion coefficients.

2. Device according to Claim 1, **characterized in that** the head (2) bears via its base on a piece (10) made of a material whose expansion coefficient is greater than that of the surrounding material.

3. Device according to either of Claims 1 and 2, **characterized in that** the end of the head (2) has a plane surface designed to flatten the wire (7, 7a, 7b) against a pad (9) on the integrated circuit (8), the said surface being slightly inclined so as to form an edge with the lateral surface, making a sharp angle (6) designed to weaken the wire on the side facing the end (7b) to be cut off from the wire, in order to allow it to be easily separated.

4. Device according to one of Claims 1 to 3, **characterized in that** the end of the head (2) has, transversely to the wire (7) and on the side (7b) to be cut off, an edge making an angle (α) different from 90° with the direction of the wire.

5. Device according to either of Claims 3 and 4, **characterized in that** the tip of the head (2) is cut in such a way as to form four facets, one of which makes an angle of about 45° with the plane of the integrated circuit (8), the angle made between this facet and the plane face of the end being rounded or broken, whereas the other three facets make an angle of about 60° with the plane of the integrated circuit.

6. Device according to any one of Claims 1 to 5, **characterized in that** it is provided with means for applying vibrations during the joining operation.
